(19)

**Europäisches Patentamt**
**European Patent Office**
**Office européen des brevets**

(11) **EP 4 585 942 A1**

(12) **EUROPEAN PATENT APPLICATION**

(43) Date of publication:
**16.07.2025 Bulletin 2025/29**

(21) Application number: **24151353.0**

(22) Date of filing: **11.01.2024**

(51) International Patent Classification (IPC):
**G01R 31/367** (2019.01)   **G01R 31/396** (2019.01)

(52) Cooperative Patent Classification (CPC):
**G01R 31/396; G01R 31/367**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Volvo Car Corporation
405 31 Göteborg (SE)**

(72) Inventors:
• **Fridholm, Björn
41462 Göteborg (SE)**
• **Hatefi, Arash
Concord, 94521 (US)**

(74) Representative: **Nederlandsch Octrooibureau
P.O. Box 29720
2502 LS The Hague (NL)**

(54) **ADVANCED FAULT DETECTION IN BATTERY CELLS**

(57)   A method for detecting faults in a battery pack comprising a plurality of groups of cells comprises monitoring one or more behaviour characteristics of the plurality of groups of cells over time; and raising a fault alert when one or more changes in a behaviour characteristic of one or more groups is detected to exceed a threshold when compared with changes in behaviour characteristics of the plurality of groups.

# FIG. 2B

**200**

EP 4 585 942 A1

## Description

### TECHNICAL FIELD

The present disclosure relates to monitoring and fault detection for battery cells, for example, in traction batteries used for propulsion in electric vehicles.

### BACKGROUND OF THE INVENTION

Efforts have been made to improve performance of the traction battery in vehicles through a Battery Management System ("BMS)", for example, detecting faults in connections, sensors, etc. However, faults can also happen inside cells. Such faults can be due to many different causes, for example, production defects or incorrect usage, and may lead to internal short circuit events that could result in a catastrophic failure of a battery. Therefore, it is important to detect faulty cells before they turn catastrophic.

The methods for this detection mainly fall into two categories: model-based and non-model-based methods. They differ in the extent to which they rely on accessing a model of the battery's behavior. Model-based approaches are often simple and can be cost-effective, but their accuracy depends on the fidelity of the model, which may be limited due to the complex characteristics of many batteries, including lithium-ion batteries.

Non-model-based methods do not require a physical model to function. Machine learning (ML) methods fall into this category, and have shown promising results in improving the safety, performance, and reliability of battery systems. Their ability to deal with uncertainties and learn the dynamics of complex systems, such as lithium-ion cells, has helped them to overtake classic data-driven methods, like signal processing approaches, in academic literature. However, it is important to note that, like most other data-driven methods, ML algorithms mostly disregard all the prior knowledge on the battery physics. Additionally, sometimes these algorithms heavily rely on data from the entire birth-to-death lifespan of cells to learn the underlying dynamics, which is typically not feasible to collect. Alternatively, such models rely on data from faulty cells, which is not available in a large scale due to the scarcity of most cell faults.

The diversity of faults in cells, coupled with their unknown development mechanisms poses challenges in detecting faults based on specific symptoms from current data. The prior art methods of detecting faults either rely on inaccurate modelling (which is too simple for the complex characteristics of LIBs) or computational complexity and large amounts of data which are not readily available. Thus, a better method for detecting faults in battery cells, and using that for taking appropriate actions is desired.

### SUMMARY OF THE INVENTION

According to a first aspect, a method for detecting faults in a pack comprising a plurality of groups of cells is disclosed. Optionally, this can be a battery pack formed of groups of battery cells, for example, lithium-ion battery cells. The method comprises monitoring one or more behaviour characteristics of the plurality of groups of cells over time; and raising a fault alert when one or more behaviour characteristic of one or more groups show unusual change comparing to the change in similar behaviour characteristics of the plurality of groups. This is possible by considering a threshold for the valid change in behaviour of group, based on the plurality of groups to isolate other exaggerated changes, which may correspond to a fault. Such a method allows for monitoring and detecting faults in cells without the need to have large past data sets or rely on inaccurate modelling (as prior art methods did). Instead, the method monitors behaviour characteristics of the groups of cells and raises a fault alert when one group exceeds a threshold, for example, has a rapid and/or exaggerated change in behaviour compared with the change behaviour of all groups, thus using real time data to detect and identify faults, allowing for providing alerts as needed.

According to an embodiment, the behaviour characteristics monitored comprise one or more of: voltage measurements and current measurements. Monitoring such characteristics can be easily done and used with the disclosed methods to determine whether a fault alert should be raised.

According to an embodiment, the step of monitoring one or more behaviour characteristics of the plurality of groups of cells over time comprises monitoring the voltage of each cell of the plurality of cells over time. By monitoring the voltage of each cell over time, any faults or irregularities can be traced to an individual cell, thereby indicating any individual faulty cells before they could potentially turn hazardous and/or catastrophic for the group.

According to an embodiment, the step of changes exceeding a threshold in one or more behaviour characteristics of one or more groups compared with changes in behaviour characteristics of the plurality of groups comprises monitoring changes in voltage cross-correlation for each of the plurality of groups over time; and detecting a change in the cross-correlation of at least one of the plurality groups exceeding a threshold related to an average voltage cross-correlation change for the plurality of groups over time. The step of monitoring changes in voltage cross-correlation for each of the plurality of groups over time can comprise, for each group, calculating first and second cross-correlations for different time intervals; and doing a comparison of the cross-correlations. Thus, for each cell group, metrics can be calculated representing the changes in cross-correlation between two time spans. The metrics are expected to be roughly similar for all groups as the cell groups are expected to change behaviour generally synchronously and at the same rate over time. Therefore, if one of the metrics differ significantly from others, it can indicate a fault in the corresponding cell group. Detection of such an outlier behaviour can be possible by setting a threshold based on average metric values. Thus, such monitoring and calculating cross-correlations, and then doing a comparison with the behaviour characteristics of the plurality of groups over time allows for detecting faults or irregularities at an earlier stage than other prior art methods and with more particularity as to the group of cells which are experiencing the irregularity or fault despite behaviour characteristics changing over time in the cells and groups of cells.

According to an embodiment, the steps of calculating first and second cross-correlations for different time intervals; and doing a comparison of the cross-correlations comprises, for each group, calculating a first covariance matrix of voltage readings for the group over a first time interval; and calculating a second covariance matrix of voltage readings for the group over a second time interval. Additionally, the method includes calculating a comparison metric by comparing the first covariance matrix and second covariance matrix by calculating variations in eigenvalues and/or eigenvectors between the first covariance matrix and the second covariance matrix to find changes in the group's behaviour characteristics. Eigenvalues and eigenvectors can be found using eigenvalue decomposition. Calculating first and second covariance matrices represented by a set of eigenvalues and eigenvectors for each group allows for a precise comparison of the changes of cell behaviour characteristics over time intervals, thereby allowing for calculation of a comparison metric for determining the threshold, and if any groups exceed the threshold.

According to an embodiment, the step of comparing the first covariance matrix and second covariance matrix by calculating the variations in eigenvalues and/or eigenvectors comprises calculating the variations in only a subset of eigenvalues and/or eigenvectors. Thus, this can result in more accuracy by only considering the part of eigenvalues and eigenvectors that contain information regarding the faultiness of cells.

According to an embodiment, the step of comparing the first covariance matrix and second covariance matrix by calculating the variations in eigenvalues between the first covariance matrix and the second covariance matrix to find changes in cross-correlation for the group comprises approaches such as comparing the product of eigenvalues for each matrix (i.e. eigenvalues matrix determinant), finding the Pearson correlation between eigenvalues, etc. The listed approaches can also be applied to a subset of eigenvalues as described previously.

According to an embodiment, the step of comparing the first covariance matrix and second covariance matrix by calculating the variations in eigenvectors between the first covariance matrix and the second covariance matrix to find changes in cross-correlation for the group comprises calculating the displacement (e.g., angle and/or distance) between the eigenvectors. Metrics such as Euclidean distance, Pearson correlation, Subspace angle, etc. can be used for such calculations.

Such calculations provide a metric to measure the changes in group behaviours through time and isolate any demonstrating irregular patterns. Through this, the behaviour can easily be compared to detect if there are irregularities or outliers amongst the cells and/or groups of cells.

According to an embodiment, the step of detecting that one or more changes in a behaviour characteristic of one or more groups exceed a threshold when compared with changes in behaviour characteristics of the plurality of groups comprises identifying outliers amongst the groups of cells by comparing the comparison metric of each of the groups. Optionally, this can be done using one or more statistical outlier detection methods, such as 3-sigma, Machine Learning algorithms, or K-Means clustering. Any of these methods, or others can be used to determine the threshold of what is normal or typical behaviour characteristics over time and what should be recognized and/or alerted as an outlier, indicating a possible fault or irregularity.

According to an embodiment, when an outlier is identified, it represents that changes in behaviour characteristics of the outlier cell are happening at an irregular pace when compared to the other pluralities of cells, which is a sign of a fault. The next step is to raise a fault alert according to the identification of the outlier. Such exceeding of a threshold can indicate that the group has experienced rapid and/or exaggerated changes in behaviour characteristics compared with the groups being monitored. Raising an alert can allow for inspection and/or replacement before any irregularities could potentially turn hazardous or catastrophic.

According to an embodiment, the step of raising a fault alert further comprises identifying a cell associated with the outlier. Optionally, this is done by examining each cell's contribution to the overall change from the first covariance matrix and second covariance matrix. For example, the cell with the maximum contribution is the faulty cell. Such a method allows for detecting and pinpointing any individual cells which could be faulty at an early stage, where intervention can be done to inspect and/or replace as necessary.

According to an embodiment, each group of cells is a battery module. This can be, for example, in a modular battery pack made of a plurality of modules (e.g., as long as they are identical). In other battery packs, clusters of cells with similar circuitry and connections can be considered as groups. Other groupings could also be used. Such a method of grouping cells and studying the cross correlation allows timely detection of faults at a low computational and memory cost.

According to a further aspect, a system comprises a battery comprising a plurality of cells; and a battery management system configured to perform the methods previously discussed. Optionally, such a battery management system can be in or part of a vehicle. Such a system can more easily and earlier detect any irregular cell variations over time by monitoring the cross-correlations across groups of cells. Thus, the changes in cell behaviour characteristics are monitored overtime, and any significant changes in the cross-correlations are distinguishable from the variations in cross-correlation observed across all groups, thereby allowing for detecting irregularities and alerting to a possible fault at an early stage by the battery management system. Thus, the system (and vehicle) can better and earlier detect, alert about, inspect and/or fix any possible irregularities in cells or groups of cells.

The person skilled in the art will understand that the features described above may be combined in any way deemed useful. Moreover, modifications and variations described in respect of the system may likewise be applied to a method.

## BRIEF DESCRIPTION OF THE DRAWINGS

In the following, aspects of the invention will be elucidated by means of examples, with reference to the drawings.

FIG. 1A illustrates a schematic diagram of vehicle with a battery management system;
FIG. 1B illustrates a schematic diagram of a battery with a plurality of groups, each formed of a plurality of cells;
FIG. 1C illustrates a schematic depiction of a Battery Management system in communication with related systems;
FIG. 2A illustrates a schematic flowchart of a method for detecting faults in a cell or group of cells;
FIG. 2B is a schematic illustration of the method of FIG. 2A in combination with the various measurements and calculations related to the method;
FIGS. 3A illustrates an example first covariance matrix with principle and residual directions depicted; and
FIGS. 3B-3C illustrate example second covariance matrices with principle and residual directions depicted.

## DESCRIPTION

Embodiments of the present disclosure will be described herein below with reference to the accompanying drawings. However, the embodiments of the present disclosure are not limited to the specific embodiments and should be construed as including all modifications, changes, equivalent devices and methods, and/or alternative embodiments of the present disclosure.

The terms used in describing the various embodiments of the present disclosure are for the purpose of describing particular embodiments and are not intended to limit the present disclosure. As used herein, the singular forms are intended to include the plural forms as well, unless the context clearly indicates otherwise. All of the terms used herein including technical or scientific terms have the same meanings as those generally understood by an ordinary skilled person in the related art unless they are defined otherwise. The terms defined in a generally used dictionary should be interpreted as having the same or similar meanings as the contextual meanings of the relevant technology and should not be interpreted as having ideal or exaggerated meanings unless they are clearly defined herein. According to circumstances, even the terms defined in this disclosure should not be interpreted as excluding the embodiments of the present disclosure.

The term "vehicle" as used herein refers to a thing used for transporting people or goods. Automobiles, cars, trucks, or buses etc. are examples of vehicles. The term "electric vehicle (EV)" as used herein refers to a vehicle, powered by an electric motor that draws current from an on-vehicle energy storage device, such as a battery, which is rechargeable from an off-vehicle source, such as residential or public electric service or an on-vehicle fuel powered generator. The EV may be two or more wheeled vehicles manufactured for use primarily on public streets, roads. The EV may be referred to as an electric car, an electric automobile, an electric road vehicle (ERV), a plug-in vehicle (PV), a plug-in vehicle (xEV), etc., and the xEV may be classified into a plug-in all-electric vehicle (BEV), a battery electric vehicle, a plug-in electric vehicle (PEV), a hybrid electric vehicle (HEV), a hybrid plug-in electric vehicle (HPEV), a plug-in hybrid electric vehicle (PHEV), etc.

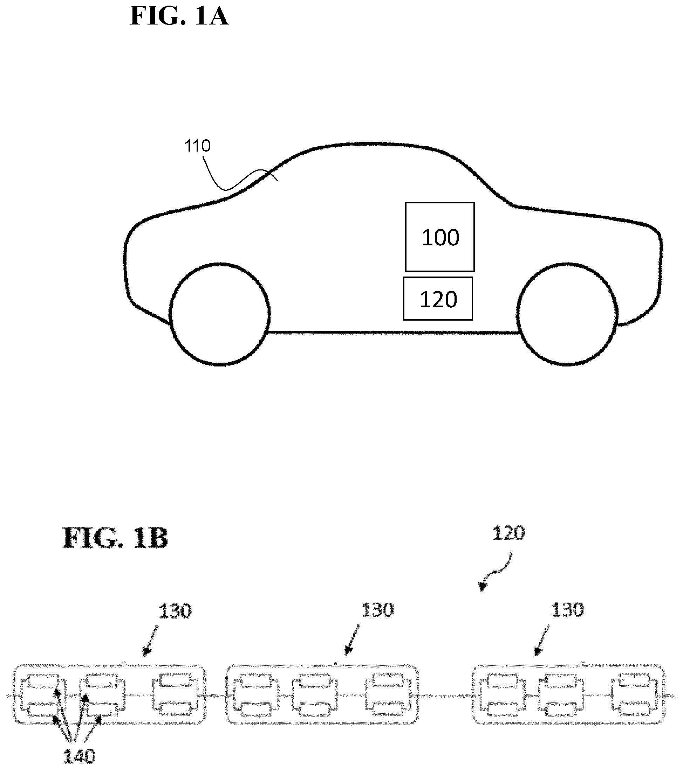

FIG. 1A shows a vehicle 110 with a battery management system 100 for managing battery 120, and Figure 1B shows a schematic view of battery 120 with a plurality of groups 130 (e.g., modules in a battery pack module), each group 130 formed of a plurality of cells 140 grouped together to form the group 130. As can be seen in FIG. 1B, the groups 130 are then connected to each other. While three groups 130 are depicted, battery 120 could be formed by any number of groups 130, and similarly, the depiction of the number of cells 140 in each group 130 is for example purposes only and could vary. While Fig. 1A shows a vehicle 110, battery management system 100 could be used or associated with another battery system not associated with a vehicle but formed of a plurality of battery cells, for example, for stationary energy storage applications.

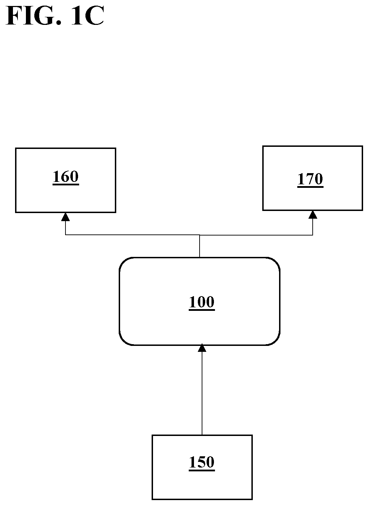

Battery management system 100, shown schematically in Figure 1C, can comprise a control unit with processors and/or any other components needed to perform method 200 for detecting faults in a cell or group of cells. One or more sensors 150 can send signals to battery management system 100, for example, voltage and/or current signals from the plurality of cells 140. Battery management system 100 then can communicate to give a driver or user of the vehicle 110 an alert or information, for example, visually on a user interface or display screen 160 (or could be audibly or haptically communicated). Battery management system 100 can also communicate with a service center 170 or other vehicle control center to communicate information about the battery 120.

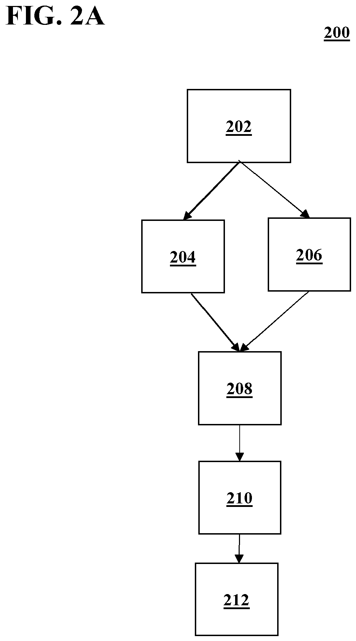

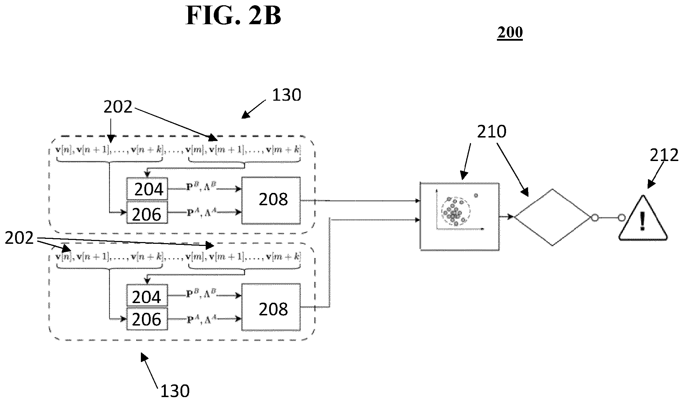

Method 200, shown in Figure 2A as a schematic flowchart and depicted with a plurality of groups 130 in Figure 2B, provides a method for detecting faults or irregularities in battery 120 formed a plurality of modules 130. Each group 130 is formed of a plurality of cells 140, for example, lithium-ion battery cells.

Method 200 starts with step 202 of monitoring one or more behavior characteristics of the cells and groups of cells over time. This can be through monitoring voltage (though in other embodiment could include also or in alternative monitoring current) of each cell overtime, and can use sensors 150, which communicate with battery management system 100, to monitor the voltage.

Steps 204-210 relate to detecting whether one or more changes in a behavior characteristic of one group is detected to exceed a threshold when compared with changes in behavior characteristics of the plurality of groups.

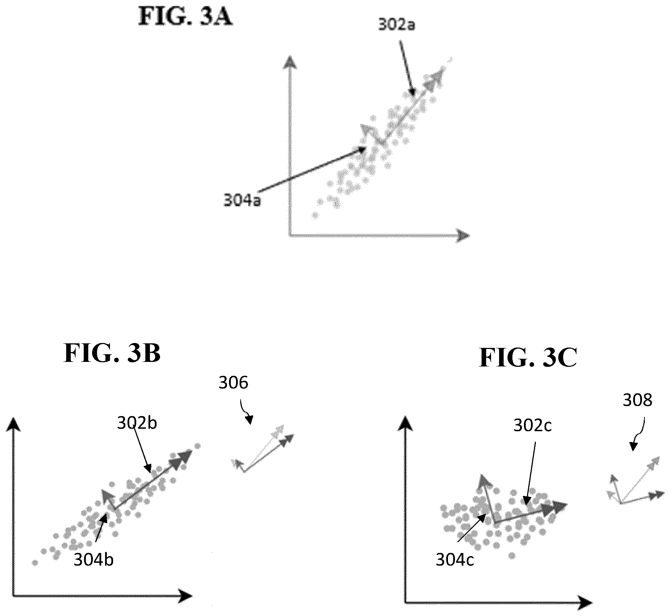

Step 204 calculates first cross-correlations for a first time interval; and step 206 calculates second cross-correlations for a second time interval for each group 130 of cells (in this example, each module 130). The calculations can be done by calculating a first covariance matrix of voltage readings for each group over the first time interval (see Fig. 3A); and calculating a second covariance matrix of voltage readings for each group over a second time interval (see Fig. 3B or 3C). The first covariance matrix and second covariance matrix are each represented by a set of eigenvalues and eigenvectors via eigenvalue decomposition. These calculations can be done using eigen value decomposition, and an example first set is shown in Figure 3A, with example second sets shown in Figures 3B-3C.

In step 208, a comparison metric is calculated by comparing the first covariance matrix and second covariance matrix by calculating variations in eigenvalues and/or eigenvectors between the first covariance matrix and the second covariance matrix to find changes in the group's behavior characteristics. This can be all or only a subset of eigenvalues and/or eigenvectors, for example, depending on the measurements taken and/or experiments and simulation according to the specific battery type . The eigenvector and/or eigenvalue subset can be determined by use of the principal and residual direction concepts. Calculating the variations in eigenvectors between the first covariance matrix and the second covariance matrix can be done by calculating the displacement between the eigenvectors, for example, using Sub-space angle, Eucledian distance, Pearson correlation, etc.

Calculating the variations in eigenvalues between the first covariance matrix and the second covariance matrix can be done by comparing by methods like comparing the product of eigenvalues of each matrix (which is equal to the determinant of the eigenvalue matrix), calculating the Pearson correlation between eigenvalues, etc.. It should be noted that, depending on the setup, it may also beneficial to include all the eigenvalues of the two groups - principal and residual. Doing so will result in simplifications as each of the logarithmic summations will simply become the logarithm of the determinant of the covariance matrix of the corresponding data group.

When performing on a real-world traction battery, such as battery 120 of Figure 1A, example calculations can be as follows, with battery 120 having N modules, each module having M cells. For a specific module the cell voltage can be logged twice during two intervals (first and second time intervals) with a time gap in between, with the number of samples in each interval being $N_s$, and the intervals being denoted by A and B.

The voltages obtained from a group 130 at each time step, are centered with their median and scaled with a robust approximation of their standard deviation. The next step is applying the eigen value decomposition and identifying the p principal directions as eigenvectors with the biggest corresponding eigenvalues and the residual directions as the remaining eigenvectors. These can be mathematically denoted as:

- $P_{pc}^A$ and $P_{pc}^B$ being matrices of principal directions vectors ($P_{pc}^A, P_{pc}^B \in \mathbb{R}^{M \times p}$)

- $P_{res}^A$ and $P_{res}^B$ being matrices of residual directions ($P_{res}^A, P_{res}^B \in \mathbb{R}^{M \times (M-p)}$)

- $\Lambda_{res}^A$ and $\Lambda_{res}^B$ being diagonal matrices of eigenvalues corresponding to the residual directions ($\Lambda_{res}^A, \Lambda_{res}^B \in \mathbb{R}^{(M-p) \times (M-p)}$)

- $\Lambda_{pc}^A$ and $\Lambda_{pc}^B$ being diagonal matrices of eigenvalues corresponding to the principal directions ($\Lambda_{pc}^A, \Lambda_{pc}^B \in \mathbb{R}^{p \times p}$)

- $\Lambda^A$ and $\Lambda^B$ being the diagonal metrics of all eigenvalues (

$$\Lambda^A = \begin{pmatrix} \Lambda_{pc}^A & 0 \\ 0 & \Lambda_{res}^A \end{pmatrix} \in \mathbb{R}^{M \times M}$$

and $\Lambda^B =$

$$\begin{pmatrix} \Lambda_{pc}^B & 0 \\ 0 & \Lambda_{res}^B \end{pmatrix} \in \mathbb{R}^{M \times M}$$

)

Thus, the comparison metric can be one or more of several metrics for fault detection. As described above, these metrics generally function based on considering the changes in the magnitude or angle of the principal direction 302 and residual direction 304, which can be represented by the arrows in Figs. 3A-3C. For example, if we measure two parameters from a system, the spread can change according to figures 3B and 3C. In a real battery module with n cells, however, we measure n voltages, which is typically greater than 2. An example metric that provides results on simulation data can be denoted as:

$$L = \log(\det(\Lambda_{res}^{B})) - \log\left(\det\left(\Lambda_{res}^{A}\right)\right)$$

The residual eigenvalues correspond to the magnitudes of the residual directions, and therefore, this comparison metric works by measuring the changes in the magnitude of the residual directions, as depicted in Figures 3B and 3C. Figure 3A depicts an example of a first covariance matrix with the principal direction depicted by arrow 302a and the residual direction depicted by arrow 304a. Figure 3B depicts an example second covariance matrix where there has been little changes in the principle direction 302a, 302b and the residual direction 304a, 304b, as shown by the arrow comparison 306. Figure 3C depicts an example second covariance matrix where there have been larger changes in the principal direction 302a, 302c and especially in the residual direction 304a, 304c, as shown by the arrow comparison 308. It is important to note that the example shown in Figs. 3A-3C is a simplified example, assuming sampling of two variable from a system over time, with the variables assumed to have a multivariate Gaussian distribution, and the system being non-stationary with slow changes.

Next, step 210 detects when one or more changes in a behavior characteristic of one group exceeds a threshold when compared with changes in behaviour characteristics of the plurality of groups (e.g., groups in the case of Figure 1B). This can be done by identifying outliers amongst the groups of cells by comparing the comparison metric of each of the groups. Various statistical outlier detection methods can be used for this, including but not limited to 3-sigma, and Machine Learning algorithms, such as K-Means. When an outlier is detected, the methods and systems could, in some embodiments also examine each individual cell's contribution to the overall change from the first covariance matrix and second covariance matrix to identify the one or more associated cells causing the detection of such a group as an outlier group.

Step 212 then raises an alert when an outlier is detected in step 210. Such an alert can be a visual (e.g., on a user interface 160), auditory, haptic or any other kind of alert to indicate to the driver/user and/or to a service provider or control center that there is an outlier that should be inspected and may need possible maintenance and/or replacement. Such an alert could also indicate the possible severity and/or the urgency of the inspection for the alert. Such possible severity and/or the urgency could be related to the outlier detection and level of difference with the comparison metric.

Thus, method 200 allows for detection of irregular cell voltage variations over time in a battery comprising a plurality of cells even accounting for natural cell variations (e.g., caused by change in state of charge or degradation mechanism) by monitoring changes in voltage cross-correlations amongst groups of cells overtime, and using that information to calculate comparison metrics to determine if a certain group (and in some cases individual cells) exceeds a threshold indicating the existence of an irregularity or fault that should be alerted and/or inspected. By monitoring groups of cells over time, calculating cross-correlations and doing comparisons of the cross-correlations, outliers can be identified as distinguishable (or exceeding a threshold) from the variations in cross-correlation observed across all the groups of cells. The identification of outliers or those exceeding a threshold can be done using a variety of different techniques (e.g, 3-sigma method, clustering Machine learning alogrithm such as K-means classifier, etc.). Thus, such methods allow for monitoring and detecting faults in cells without the need to have large past data sets or rely on inaccurate modelling that prior art methods used. Instead, the methods here are able to detect and alert to any possible faults earlier by monitoring real-time behaviour of groups of cells and comparing with changes in behaviour characteristics of the plurality of groups, allowing for detection of rapid and/or exaggerated changes in characteristics over time and being able to distinguish from typical time variations. Based on the detected faults, appropriate alerts and/or actions can be taken at an earlier stage making for an overall better experience for the user and possibly detecting issues before they become catastrophic.

Those skilled in the art will appreciate that the methods, systems and components described herein may comprise, in whole or in part, a combination of analog and digital circuits and/or one or more appropriately programmed processors (e.g., one or more microprocessors including central processing units (CPU)) and associated memory, which may include stored operating system software, firmware and/or application software executable by the processor(s) for controlling operation thereof and/or for performing the particular algorithms represented by the various functions and/or operations described herein, including interaction between and/or cooperation with each other as well as transmitters and receivers. One or more of such processors, as well as other digital hardware, may be included in a single ASIC (Application-Specific Integrated Circuitry), or several processors and various digital hardware may be distributed among several separate components, whether individually packaged or assembled into a SoC (System-on-a-Chip).

Furthermore, the systems, methods and components described, and/or any other arrangement, unit, system, device or module described herein may for instance be implemented in one or several arbitrary nodes comprised in the vehicle and/or one or more separate devices or systems. In that regard, such a node may comprise an electronic control unit (ECU) or any suitable electronic device, which may be a main or central node. It should also be noted that the these may further comprise or be arranged or configured to cooperate with any type of storage device or storage arrangement known in the art, which may for example be used for storing input or output data associated with the functions and/or operations described herein. The systems, components and methods described herein may further comprise any computer hardware and software and/or electrical hardware known in the art configured to enable communication therebetween.

While the invention has been described with reference to exemplary embodiments, it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiments disclosed, but that the invention will include all embodiments falling within the scope of the appended claims.

**Claims**

1. A method for detecting faults in a pack comprising a plurality of groups (130) of cells (140), the method comprising:

    monitoring one or more behaviour characteristics of the plurality of groups of cells over time; and
    raising a fault alert when one or more behaviour characteristics of one or more groups is detected to have changes exceeding a threshold when compared with changes in behaviour characteristics of the plurality of groups.

2. The method of claim 1, wherein the behaviour characteristics monitored comprise one or more of: voltage measurements and current measurements.

3. The method of claim 1, wherein the step of monitoring one or more behaviour characteristics of the plurality of groups of cells over time comprises: monitoring the voltage of each cell of the plurality of cells over time.

4. The method of claim 3, wherein detecting changes exceeding a threshold in one or more behaviour characteristics of one or more groups compared with changes in behaviour characteristics of the plurality of groups comprises:

    monitoring changes in voltage cross-correlation for each of the plurality of groups over time; and
    detecting a change in the cross-correlation of at least one of the plurality groups exceeding a threshold related to an average voltage cross-correlation change for the plurality of groups over time.

5. The method of claim 4, wherein the step of monitoring changes in voltage cross-correlation for each of the one or more groups over time comprises, for each group:

    calculating first and second cross-correlations for different time intervals; and
    doing a comparison of the cross-correlations.

6. The method of claim 5, wherein the steps of calculating first and second cross-correlations for different time intervals; and doing a comparison of the cross-correlations comprises, for each group:

    calculating a first covariance matrix of voltage readings for the group over a first time interval; calculating a second covariance matrix of voltage readings for the group over a second time interval; wherein each of the first covariance matrix and second covariance matrix is represented by a set of eigenvalues and eigenvectors via eigenvalue decomposition; and
    calculating a comparison metric by comparing the first covariance matrix and second covariance matrix by calculating variations in eigenvalues and/or eigenvectors between the first covariance matrix and the second covariance matrix to find changes in the group's behaviour characteristics.

7. The method of claim 6, wherein the step of comparing the first covariance matrix and second covariance matrix by calculating the variations in eigenvalues and/or eigenvectors comprises calculating the variations in only a subset of eigenvalues and/or eigenvectors.

8. The method of any of claims 6-7, wherein the step of comparing the first covariance matrix and second covariance matrix by calculating the variations in eigenvalues between the first covariance matrix and the second covariance matrix to find changes in cross-correlation for the group comprises:

    comparing the product of eigenvalues for each matrix, and
finding the Pearson correlation between eigenvalues.

9. The method of any of claims 6-8, wherein the step of comparing the first covariance matrix and second covariance matrix by calculating the variations in eigenvectors between the first covariance matrix and the second covariance matrix to find changes in cross-correlation for the group comprises:
calculating the angle and/or distance between the eigenvectors.

10. The method of any of claims 6-9, wherein the step of detecting one or more changes in a behaviour characteristic of one group exceeds a threshold when compared with changes in behaviour characteristics of the plurality of groups comprises:
identifying outliers amongst the groups of cells by comparing the comparison metric of each of the groups, preferably using one or more statistical outlier detection methods, preferably 3-sigma, or Machine Learning algorithms, preferably K-Means.

11. The method of any of claims 9-10, wherein when an outlier is identified, the outlier indicates that a change in a behaviour characteristic of one of the groups exceeds a threshold when compared with changes in behaviour characteristics of the plurality of groups, and the step of raising a fault alert according to the outlier is performed.

12. The method of claim 11, wherein the step of raising a fault alert further comprises identifying a cell associated with the outlier, preferably by examining each cell's contribution to the overall change from the first covariance matrix and second covariance matrix.

13. The method of any of the preceding claims, wherein each group (130) of cells is a battery module.

14. A system comprising:

a battery (120) comprising a plurality of cells (140);
a battery management system (100) configured to perform the method of any of the preceding claims.

15. A vehicle (110) or stationary energy storage comprising the system of claim 14.

FIG. 1A

FIG. 1B

# FIG. 1C

**FIG. 2A**

<u>200</u>

# FIG. 2B

<u>200</u>

## FIG. 3A

## FIG. 3B

## FIG. 3C

Europäisches
Patentamt

European
Patent Office

Office européen
des brevets

# EUROPEAN SEARCH REPORT

**Application Number**

EP 24 15 1353

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/376314 A1 (KOCH SEBASTIAN [DE] ET AL) 24 November 2022 (2022-11-24) | 1-3, 13-15 | INV. G01R31/367 G01R31/396 |
| A | * paragraph [0007] - paragraph [0055]; claims 1-3 * | 4-12 | |
| X | US 2023/152388 A1 (SUNG YONG-CHUL [KR] ET AL) 18 May 2023 (2023-05-18) | 1-3, 13-15 | |
| A | * paragraph [0048] - paragraph [0188]; claims 1, 2 * | 4-12 | |
| X | US 2022/196754 A1 (KIM JAKE [KR] ET AL) 23 June 2022 (2022-06-23) | 1-3, 13-15 | |
| A | * paragraph [0017] - paragraph [0083]; claims 1-3 * | 4-12 | |
| X | US 2022/140617 A1 (WANG YUE-YUN [US] ET AL) 5 May 2022 (2022-05-05) | 1-3, 13-15 | |
| A | * paragraph [0035] - paragraph [0047]; claims 1, 2, 12 * | 4-12 | |

TECHNICAL FIELDS SEARCHED (IPC)

G01R

The present search report has been drawn up for all claims

| Place of search | Date of completion of the search | Examiner |
|---|---|---|
| Munich | 26 June 2024 | Meggyesi, Zoltán |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 15 1353

This annex lists the patent family members relating to the patent documents cited in the above-mentioned European search report.
The members are as contained in the European Patent Office EDP file on
The European Patent Office is in no way liable for these particulars which are merely given for the purpose of information.

26-06-2024

| Patent document cited in search report | Publication date | Patent family member(s) | Publication date |
|---|---|---|---|
| US 2022376314 A1 | 24-11-2022 | CN 115372854 A | 22-11-2022 |
| | | DE 102021113211 A1 | 24-11-2022 |
| | | US 2022376314 A1 | 24-11-2022 |
| US 2023152388 A1 | 18-05-2023 | CN 115461634 A | 09-12-2022 |
| | | EP 4152021 A1 | 22-03-2023 |
| | | JP 7483922 B2 | 15-05-2024 |
| | | JP 2023519949 A | 15-05-2023 |
| | | KR 20220074797 A | 03-06-2022 |
| | | US 2023152388 A1 | 18-05-2023 |
| | | US 2023243895 A1 | 03-08-2023 |
| | | WO 2022114871 A1 | 02-06-2022 |
| US 2022196754 A1 | 23-06-2022 | CN 113785209 A | 10-12-2021 |
| | | EP 3988952 A1 | 27-04-2022 |
| | | KR 20210000206 A | 04-01-2021 |
| | | US 2022196754 A1 | 23-06-2022 |
| | | WO 2020262789 A1 | 30-12-2020 |
| US 2022140617 A1 | 05-05-2022 | CN 114441979 A | 06-05-2022 |
| | | DE 102021110152 A1 | 05-05-2022 |
| | | US 2022140617 A1 | 05-05-2022 |

EPO FORM P0459

For more details about this annex : see Official Journal of the European Patent Office, No. 12/82